(19) **Europäisches Patentamt**

**European Patent Office**

**Office européen des brevets**

(11) **EP 0 479 015 B1**

(12) **EUROPÄISCHE PATENTSCHRIFT**

(45) Veröffentlichungstag und Bekanntmachung des Hinweises auf die Patenterteilung:
**27.03.1996  Patentblatt 1996/13**

(51) Int Cl.⁶: **H03G 3/10**, H03G 3/00, H04R 25/00

(21) Anmeldenummer: **91115640.4**

(22) Anmeldetag: **14.09.1991**

(54) **Lautstärkeregler für Hörgeräte**

Gain control device for hearing aid

Dispositif de réglage de gain pour prothèse auditive

(84) Benannte Vertragsstaaten:
**AT BE CH DE DK ES FR GB GR IT LI LU NL SE**

(30) Priorität: **02.10.1990  CH 3174/90**

(43) Veröffentlichungstag der Anmeldung:
**08.04.1992  Patentblatt 1992/15**

(73) Patentinhaber: **PHONAK AG**
**CH-8712 Stäfa (CH)**

(72) Erfinder: **Bächler, Herbert, Dr.**
**CH-8706 Meilen (CH)**

(74) Vertreter: **Troesch Scheidegger Werner AG**
**Patentanwälte,**
**Siewerdtstrasse 95,**
**Postfach**
**CH-8050 Zürich (CH)**

(56) Entgegenhaltungen:
CH-A- 509 719          DE-A- 2 253 987
FR-A- 2 257 172        US-A- 4 413 235

• ELECTRONICS & WIRELESS WORLD Bd. 95, Nr. 1635, Januar 1989, Surrey, GB, SS. 17-18; J. SOUZA: "Decibel gain control"

**Beschreibung**

Die vorliegende Erfindung betrifft einen Lautstärkeregler für ein Hörgerät, welches ein Potentiometer mit linearer Widerstandscharakteristik und zugehörigem Bedienorgan und einen elektronischen Audioverstärker enthält.

Hörgeräte besitzen in der Regel wenigstens ein Aufnahmemikrofon, einen Audioverstärker und einen Wiedergabelautsprecher. Um die Wiedergabelautstärke für den Benutzer des Hörgerätes einstellbar zu machen, weisen solche Geräte einen regelbaren Audioverstärker auf, wobei die Regulierung der Lautstärke beispielsweise über einen am Hörgerät angebrachten Drehknopf erfolgt. Gerade Im-Ohr-Hörgeräte, bei welchen das ganze Hörgerät im Gehörgang des Benutzers positioniert wird, besitzen in der Regel einen miniaturisierten Drehknopf, welcher mit der Fingerspitze bedient werden kann. Herkömmlicherweise ist dieser Drehknopf direkt mit einem Potentiometer mit logarithmischer Charakteristik verbunden, welches den Audioverstärker regelt. Eine logarithmische Charakteristik ist deshalb zweckmässig, weil damit für den Benutzer durch das Verdrehen des Drehknopfes ein lineares Verändern der Wiedergabelautstärke erfolgt, da die Lautstärkeempfindung des Ohres logarithmisch zur abgegebenen Schallstärke ist.

Ein Hörgerätbenutzer benötigt in der Regel für jedes Ohr ein separates Hörgerät. Im-Ohr-Hörgeräte bestehen unter anderem aus industriell vorfabrizierten Modulen, welche die elektronischen Komponenten beinhalten, und einer individuellen Ohrschale, welche aus dem Ohrabdruck des Benutzers gefertigt wird. Bei Im-Ohr-Hörgeräten nach vorig geschilderter Bauweise kann der Benutzer nun durch gleichzeitiges Verdrehen der Drehknöpfe im linken und rechten Ohr mit jeweils einem Finger der linken resp. rechten Hand die Lautstärke regulieren. Um eine ergonomisch sinnvolle Bedienung zu gewähren muss beispielsweise zur Lautstärkeverminderung der Benutzer mit den Fingern eine Drehbewegung nach hinten ausführen. Dies bedeutet nun, dass das Potentiometer des Hörgerätes im linken Ohr nach rechts und im rechten Ohr nach links bewegt wird, also umgekehrten Drehsinn aufweisen. Deswegen müssen solche Hörgeräte jeweils für das linke resp. rechte Ohr separat gekennzeichnet sein und mit entsprechend geschalteten Potentiometern hergestellt werden.

Dies führt dazu, dass ein Hörgeräteanbieter jeweils gesondert für das linke resp. rechte Ohr Hörgeräte resp. Module am Lager halten muss und ebenso die Produktion gesondert erfolgen muss. Da gerade bei Defekten nicht immer beide Hörgeräte ausgetauscht werden müssen, stellt dies einen beachtlichen Nachteil dar, zumal solche Hörgeräte z.T. spezifisch für bestimmte Hörschäden gefertigt werden, was die Lagerhaltung und Produktion zusätzlich vergrössert und verteuert.

Die Aufgabe der vorliegenden Erfindung bestand nun darin, solche Hörgeräte resp. Module derartig auszulegen, dass ein Gerät sowohl für das linke wie auch das rechte Ohr verwendet werden kann, ohne auf eine ergonomische Lautstärkeregelung zu verzichten.

Diese Aufgabe wird erfindungsgemäss dadurch gelöst, dass ein linear-logarithmisch-Wandler vorgesehen ist, welcher vom Potentiometer angesteuert wird und seinerseits die Tonverstärkung des Audioverstärkers mit einer zur linearen Charakteristik des Potentiometers logarithmischen Charakteristik regelt, und dass ein Umschalter vorgesehen ist, welcher die logarithmische Charakteristik des Wandlers im Verhältnis zur Betätigungsrichtung des Potentiometers gleichlaufend oder umgekehrt schaltet.

Bevorzugte Ausführungsformen der Erfindung sehen vor, dass der Umschalter die Anschlüsse des Potentiometers umpolt oder dass der Umschalter an den lin-log-Wandler angeschlossen ist und dieser in Abhängigkeit der Schalterstellung ein normales oder umgekehrtes Regelsignal für den Audioverstärker liefert.

Weitere bevorzugte Ausführungsformen sehen vor, dass der Umschalter ein mechanisch bedienbarer elektrischer Umschalter ist oder der Umschalter ein elektronischer Umschalter ist, welcher von einer Steuerlogik angesteuert wird.

Ausführungsbeispiele der Erfindung werden nachstehend anhand von Zeichnungen noch näher erläutert. Es zeigen

Fig.1 das Prinzipschema eines herkömmlichen Hörgerätes a) mit Signal-Spannungsteiler als Lautstärkeregler , b) mit gesteuerter Verstärkung als Lautstärkeregler;

Fig.2. das Prinzipschema eines erfindungsgemässen Hörgerätes mit stromgesteuertem Verstärker;

Fig.3. das Prinzipschema einer Ausführungsform eines erfindungsgemässen Hörgerätes mit mechanischem Umschalter;

Fig.4 das Prinzipschema eines linear-logarithmisch Wandlers.

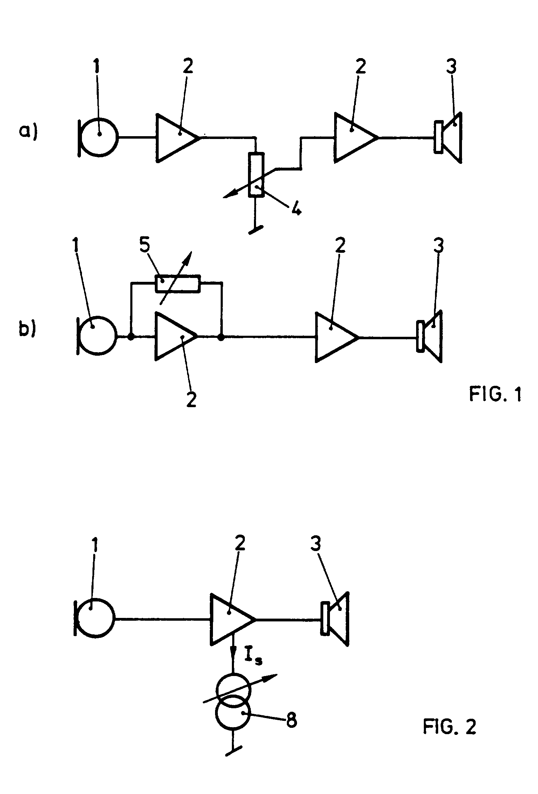

Ein Hörgerät weist herkömmlicherweise im Wesentlichen ein Aufnahmemikrofon 1 und einen elektronischen Verstärker 2 mit einem Wiedergabelautsprecher 3 auf, wie Fig. 1 zeigt.

Das logarithmische Potentiometer 4 in Fig. la) erzeugt eine dem Drehwinkel proportionale Lautstärkeänderung. Der logarithmische Regelwiderstand 5 in Fig 1b) erzeugt eine dem Drehwinkel proportionale Verstärkungs/Lautstärkeänderung.

Unter Verwendung eines Drehwiderstandes, dessen Widerstandsänderung logarithmisch zur Drehwinkeländerung verläuft, erhält man eine lineare Beziehung zwischen Drehwinkeländerung und Lautstärke, welche praktisch von allen Audiogeräten genutzt wird.

Derartige regelbare Widerstände mit logarithmischer Charakteristik können nicht beliebig umgepolt d.h.

die Bedienrichtung umgekehrt werden, das dies eine Änderung der Charakteristik zur Folge hätte.

Das grundlegende Konzept der Erfindung kann mit Hilfe von Fig.2 näher erläutert werden.

Ein Verstärker wird von einer regelbaren Stromquelle 8 gespiesen. Die elektronische Verstärkung G der aufgenommenen Schallwellen ist proportional zum Verstärkerstrom Is. Die Lautstärkeempfindung L des Ohres ist logarithmisch zur vom Lautsprecher abgegebenen Schalleistung und damit auch zur Verstärkung G. Setzt man diese Komponenten grob zueinander in Beziehung, erhält man eine Abhängigkeit der Lautstärkeempfindung L zur Änderung des Stromes Is:

$$I. \quad L \sim \log G \sim \log Is$$

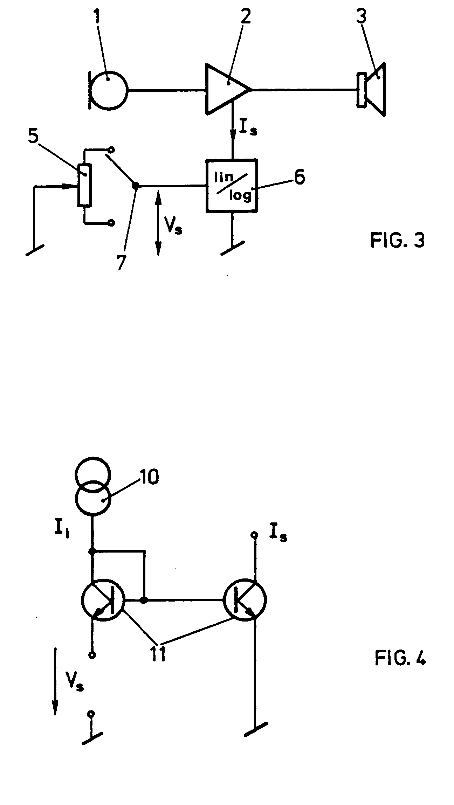

Eine Ausführungsform der regelbaren Stromquelle Is ist in Fig.3 dargestellt. Zwei Anschlüsse des regelbaren Widerstandes 5 sind über einen mechanischen Umschalter 7 mit einem linear-logarithmisch-Wandler 6 verbunden, der den Steuerstrom Is für die Lautstärkeregelung des Verstärkers 2 liefert. Der Widerstand 5, beispielsweise als Drehpotentiometer ausgeführt, weist eine lineare Widerstandscharakteristik auf und ist derartig geschaltet, dass er dem lin-log-Wandler 6 eine proportional zur Verdrehrichtung veränderbare Steuerspannung Vs einstellt. Der vom Wandler 6 abgegebene Steuerstrom Is ist nun entsprechend seiner Charakteristik exponentiell proportional zur Widerstandsänderung R :

$$II. \quad Is \sim \exp(Vs) \sim \exp(R)$$

Berücksichtigen wir nun die Zusammenhänge I. und II., so lässt sich schreiben :

$$L \sim \log Is \sim R$$

Die Lautstärke verändert sich damit linear mit der Drehwinkeländerung des Potentiometers 5. Mittels des Umschalters 7 kann nun die Drehrichtung des Potentiometers umgekehrt werden, d.h. die Nullstellung beispielsweise vom linken zum rechten Anschlag verschoben werden, wobei die Charakteristik des Steuerstromes Is unverändert bleibt. Dieser Umschalter 7 ist hier beispielsweise als miniaturisierter mechanischer Schalter ausgeführt, kann aber auch aus einem elektronischen Schalter bestehen. Ein solcher elektronischer Schalter wird vorzugsweise in elektronischen Im-Ohr-Hörgeräten mit digitaler Steuerlogik eingesetzt und von dieser Steuerlogik angesteuert. Vorzugsweise wird dann ein digitaler lin-log-Wandler mit integriertem Umschalter verwendet, wodurch auf ein Umpolen der Anschlüsse des Potentiometers 5 verzichtet werden kann.

In Fig.4 ist noch ein möglicher Aufbau eines lin-log-Wandlers mittels Transistoren 11 dargestellt. Die Schaltung wird von einer Stromquelle 10 mit einem Referenzstrom Ii versorgt und stellt den Steuerstrom Is in Abhängigkeit zur Steuerspannung Vs wie gewünscht ein:

$$Is \sim Ii \exp(Vs)$$

## Patentansprüche

1. Lautstärkeregler für ein Hörgerät, welches ein Potentiometer mit linearer Widerstandscharakteristik und zugehörigem Bedienorgan und einen elektronischen Audioverstärker enthält, dadurch gekennzeichnet, dass ein linear-logarithmisch-Wandler vorgesehen ist, welcher vom Potentiometer angesteuert wird und seinerseits die Tonverstärkung des Audioverstärkers mit einer zur linearen Charakteristik des Potentiometers logarithmischen Charakteristik regelt, und dass ein Umschalter vorgesehen ist, welcher die logarithmische Charakteristik des Wandlers im Verhältnis zur Betätigungsrichtung des Potentiometers gleichlaufend oder umgekehrt schaltet.

2. Lautstärkeregler nach Anspruch 1, dadurch gekennzeichnet, dass der Umschalter die Anschlüsse des Potentiometers umpolt.

3. Lautstärkeregler nach Anspruch 1, dadurch gekennzeichnet, dass der Umschalter an den Wandler angeschlossen ist und dieser in Abhängigkeit der Schalterstellung ein normales oder umgekehrtes Regelsignal für den Audioverstärker liefert.

4. Lautstärkeregler nach einem der Ansprüche 1 bis 3, dadurch gekennzeichnet, dass der Umschalter ein mechanisch bedienbarer elektrischer Umschalter ist.

5. Lautstärkeregler nach einem der Ansprüche 1 bis 3, dadurch gekennzeichnet, dass der Umschalter ein elektronischer Umschalter ist, welcher von einer Steuerlogik angesteuert wird.

## Claims

1. Gain control device for hearing aid, comprising a potentiometer with a linear resistance characteristic, a control element and an electronic audio amplifier, characterized by a linear-logarithmic transducer conrolled by said potentiometer and controlling the sound amplification of said audio amplifier with a characteristic which is logarithmic with respect to said linear characteristic, and by a switch controlling in the same or reverse sense the logarithmic characteristic of the transducer in relation to the direction of operation of said potentiometer.

2. Device according to claim 1, characterized in that said switch is changing the polarity of the terminals of said potentiometer.

3. Device according to claim 1, characterized in that the switch is connected to the transducer, the latter producing, depending from the position of the switch, a normal or reverse control signal.

4. Device according to any of claims 1 to 3, characterized in that the switch is a mechanically operable electric switch.

5. Device according to any of claims 1 to 3, characterized in that the switch is an electronic switch operable by a control logic.

**Revendications**

1. Dispositif de réglage de gain pour prothèse auditive, comprenant un potentiomètre à caractéristique de résistance linéaire, un organe de commande et un audio-amplificateur électronique, caractérisé par un transducteur linéaire-logarithmique commandé par ledit potentiomètre et réglant à son tour l'amplification du son de l'audio-amplificateur avec une caractéristique logarithmique par rapport à la caractéristique linéaire du potentiomètre et par un commutateur réglant la caractéristique logarithmique du transducteur par rapport à la direction de commande du potentiomètre dans le même sens ou dans le sens inverse.

2. Dispositif de réglage selon la revendication 1, caractérisé en ce que le commutateur change la polarité des bornes du potentiomètre.

3. Dispositif de réglage selon la revendication 1, caractérisé en ce que le commutateur est branché au transducteur, ce dernier produisant en fonction de la position du commutateur un signal de réglage normal ou inversé pour l'audio-amplificateur.

4. Dispositif de réglage selon l'une des revendications 1 à 3, caractérisé en ce que le commutateur est un commutateur électrique à commande mécanique.

5. Dispositif de réglage selon l'une des revendications 1 à 3, caractérisé en ce que le commutateur est un commutateur électronique commandé par une logique de commande.

FIG. 1

FIG. 2

FIG. 3

FIG. 4